# EUROPEAN PATENT APPLICATION

(11) **EP 0 917 199 A2**
(43) Date of publication of application: **19.05.1999**
(21) Application number: 98203870.5
(22) Date of filing: 13.11.1998
(51) Int. Cl.: H01L 23/532

(54) **Improvements in or relating to semiconductor devices**

(30) Priority: 17.11.1997 US 65927 P
(71) Applicant: TEXAS INSTRUMENTS INCORPORATED, Dallas, TX 75265 (US)
(72) Inventor: Taylor, Kelly J., Allen, TX 75002 (US); Jin, Changming, Dallas, TX 75243 (US)
(74) Representative: Holt, Michael

(57) **Abstract**

A semiconductor device including a plurality of devices formed on an integrated circuit. A sacrificial layer (102) is formed over a surface of a semiconductor substrate (101) and patterned to form troughs (103). The troughs (103) are filled with a conductor (104) to form interconnect lines (106). The sacrificial layer (102) is removed and a low-ε dielectric (107) is applied to a surface of the integrated circuit to fill between the interconnect wires (106) inlaid in the low-ε dielectric (107). The interconnect wires (106) are formed so as to interconnect at least portions of the devices.

## Description

### Field of the Invention.

The present invention relates, generally, to semiconductor device structures and processing, and, more particularly, to an interconnect structure and process with lower line resistance and lower line-to-line capacitance.

### Background of the invention

Modern integrated circuits use multiple layers of fine-pitched interconnect wiring to conduct signals between device components. As the wiring becomes thinner, its resistance per unit length becomes greater. Also, as circuits become more complex, the length of the interconnect wires becomes longer. With the continued scaling of silicon integrated circuit (IC) devices, resistor-capacitor (RC) characteristics of the conductive interconnects have become a dominant limiting factor in circuit performance.

Thinner, longer wires result in high resistance interconnects. Further, as dielectric layers become thinner and the spacing between adjacent wires becomes smaller in fine-pitched devices, the capacitance within devices increases. In addition to RC delays, line-to-line capacitance can increase to a point that crosstalk (i.e., capacitive coupling of a signal between nearby wires) can limit performance. Moreover, in complex high speed circuits the power loss in high RC interconnect lines is a significant contribution to device power dissipation that increases heating and reduces battery life in battery powered applications.

Silicon dioxide is the most common dielectric material used to isolate wires from each other. Silicon dioxide has a characteristic relative dielectric permittivity or dielectric constant of about 4.1. The relative dielectric constant is based on a scale where 1.0 represents the dielectric constant of a vacuum. As used herein, the term "thin film low permittivity dielectric" means a dielectric that can be applied to a semiconductor substrate surface using available thin film techniques and has a characteristic relative dielectric permittivity constant less than about 3.5. A wide range of organic and inorganic materials are being developed to provide low permittivity (i.e., low ε) performance. Examples include fluorine doped silicon dioxide, parylene, aerogel, and fluorinated polymers. Materials and processes are needed that can combine these low-ε films with integrated circuit processing in combination with high conductivity metals and conductors to reduce RC time constants. The use of low RC materials is vital to the continued scaling and performance improvement of integrated circuits.

Aluminum (Al) is the most common metal used to form patterned interconnect wiring in view of its low cost and well understood processing. However, Al has relatively low conductivity compared to other conductors such as gold, copper and their alloys. Copper and its alloys are attractive substitutes for Al interconnect wiring because copper is inexpensive and has higher reliability and conductivity. However, copper interconnects involve more complex processing than aluminum. In particular, copper is difficult to etch using dry etch processes such as reactive ion etching (RIE) as available etch processes do not yield gas phase copper by-products. Wet etching is inconsistent with smaller geometry device structures.

Damascene processes are desirable for copper interconnects because they provide fine patterned features without dry-etching the copper. A Damascene process begins with etching both contacts and troughs for the wiring into a thick, planarized silicon dioxide layer. Metal is deposited to fill the contacts and troughs and then removed from the surface using chemical mechanical planarization (CMP) techniques. This leaves the wiring inlaid in the insulator with wiring size and contact size determined by the etch process(es) used to form the contacts and troughs. The resulting surface is flat so there is no need for expensive planarization processing between the first and second layer of wiring. Hence, subsequent interlayer dielectric layers can be formed with a single deposition. Because the metal is removed from the surface with CMP instead of RIE, difficult etching depth control problems and related RIE-induced defects are eliminated.

Low-ε materials can be used to reduce line-to-line capacitance between adjacent lines in a single metal layer as well as reducing capacitance created by interlevel dielectric materials between overlying metal wires. Lowering the line-to-line capacitance by selectively embedding a low-ε material between adjacent lines is an effective way to lower the total interconnect capacitance and thereby reduce the RC time delays, allowing faster intra-chip communications. Cross-talk voltage interference between adjacent metal wires can also be reduced by embedding a low-ε material solely between the wires but not above or below the wires. Currently, most low-ε dielectric materials are difficult to integrate into conventional IC processing flows because of such limitations as out-gassing, low thermal stability, low mechanical strength, and the like. For this reason, many processes use the low-ε materials in conjunction with conventional insulators such as oxides that cap the low-ε material to prevent outgassing and provide mechanical strength and ruggedness in areas where device structures such as contacts are to be formed.

A need exists for IC processes that incorporate both low-ε dielectric materials and copper in an integrated circuit. It is particularly desirable to include high conductivity and low-ε dielectric materials in a Damascene process. However, prior Damascene processing has required homogenous interlayer dielectric materials that excluded many promising low-ε dielectric materials that must use a cap layer.

### SUMMARY OF THE INVENTION

Briefly stated, the teachings disclosed herein involve a semiconductor device including a plurality of devices formed on an integrated circuit. A low-ε dielectric on a surface of the integrated circuit has interconnect wires inlaid in the dielectric. The interconnect wires are formed so as to interconnect at least portions of the devices. Desirably the interconnect wires comprise copper.

Another aspect of these teachings involve a method for forming an integrated circuit including the steps of forming a sacrificial layer over a surface of a semiconductor substrate and patterning the sacrificial layer to form troughs in the sacrificial layer. The troughs are filled with a conductor comprising copper to form interconnect lines. A remainder of the sacrificial layer is removed and spaces between the conductor are filled with a low-ε dielectric.

### BRIEF DESCRIPTION OF THE DRAWINGS

The present invention will now be further described, by way of example, with reference to the accompanying drawings in which:
FIG. 1 shows a cross section of a portion of an integrated circuit including an interconnect structure at an early stage in processing;
FIG. 2 shows the structure shown in FIG. 1 at a later stage in processing;
FIG. 3 shows the structure of FIG. 2 after an intermediate planarization step;
FIG. 4 shows in cross section the structure of FIG. 3 after further in processing;
FIG. 5 shows the structure of FIG. 4 after formation of an insulating layer;
FIG. 6 shows the structure of FIG. 5 after removal of the insulating layer from the open areas of the interconnect structure;
FIG. 7 illustrates the structure of FIG. 6 still further in processing;
FIG. 8 illustrates the structure of FIG. 7 after a subsequent planarization step;
FIG. 9 shows the interconnect structure after formation of contact openings;
FIG. 10 shows the interconnect structure at a late stage in processing
FIG 11 illustrates a second embodiment process at a processing stage subsequent to that shown in FIG. 8;
FIG. 12 illustrates the second embodiment at a further stage in processing;
FIG. 13 shown the structure of FIG. 12 still further in processing;
FIG. 14 shows the second embodiment interconnect structure after formation of second layer of conductive wiring; and
FIG. 15 illustrates the second embodiment in a cross-sectional view late in processing.

### DETAILED DESCRIPTION OF THE PREFERRED EMBODIMENTS

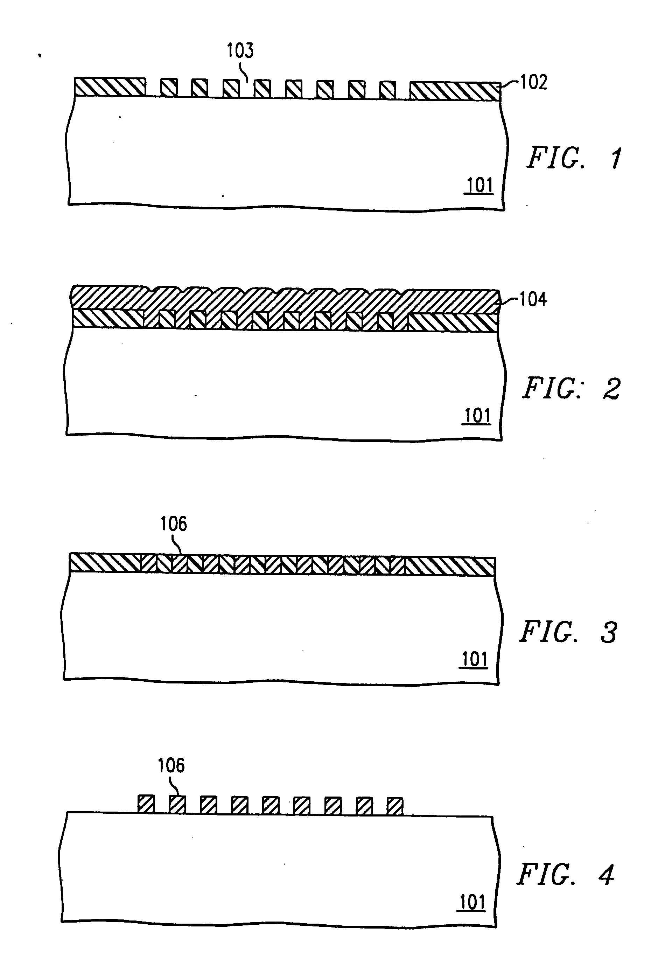

The disclosed teachings are useful in integrated circuit interconnect structures used to couple selected ones of a plurality of devices formed in the integrated circuit. For ease of illustration and understanding, FIG. 1-FIG. 15 illustrate the interconnect structure in cross section without showing the particular devices formed in and on the semiconductor body 101. Formation of a wide variety of devices including diffused transistors, thin film transistors, capacitors, resistors, inductors and the like are well known. These teachings are useful for providing low RC connections between any combination of these devices to meet the needs of a particular application.

Semiconductor body 101 comprises silicon, germanium, III-V compound semiconductor, II-VI compound semiconductor or the like in any combination. Semiconductor body 101 may be formed as a single layer or may comprise multiple layers of distinct materials. Semiconductor body 101 may be self supporting or formed on a supporting substrate such as ceramic, sapphire, diamond, glass, or the like to meet the needs of a particular application.

The interconnect structure and method is described in terms of a Damascene-like process that enables use of conductive materials that are difficult to dry etch. Particularly, the disclosed teachings use a copper or copper alloy metal to form interconnect wiring, although the disclosed principles may be extended to other metal systems including conventional metal systems that can be dry etched. These teachings are an extension of U.S. Patent 5,486,493 assigned to the assignee of the present application entitled "PLANARIZED MULTI-LEVEL INTERCONNECT SCHEME WITH EMBEDDED LOW-DIELECTRIC CONSTANT INSULATORS". Accordingly, materials and material thicknesses are specified herein for example only, and are not limitations on the essential teachings disclosed herein unless expressly stated.

In FIG. 1, semiconductor body 101 is coated with a sacrificial or disposable layer 102 that is patterned to provide openings 103. In a particular example, sacrificial layer 102 is patterned by photolithography techniques. Conveniently, sacrificial layer 102 comprises photoresist applied in a uniform layer by spinning or spraying and patterned using conventional photoresist processing techniques. Sacrificial layer 102 is applied at a thickness selected to provide sufficiently low resistance per unit length to wires 106 (shown in FIG. 3). Thickness of sacrificial layer 102 is typically in the range of 0.1 to 2.0 microns in a particular example, although this thickness may change to meet the needs of a particular application.

Alternatively, sacrificial layer 102 may comprise any material that can be applied in a substantially uniform layer, is patternable, and that can be sacrificially etched away without substantially etching or damaging wires 106 (shown in FIG. 3). Unlike conventional Damascene processes, the material chosen for sacrificial layer 102 will be removed and so will not affect the line-to-line capacitance between wires 106. This feature of the disclosed teachings gives great flexibility in the selection of sacrificial layer 102. By enabling selection among photoresist, polymers, oxides, and even conductors such as silicon and metal, the teachings disclosed herein are easily adaptable to integration with other processes and devices that may be formed in or on semiconductor body 101.

As shown in FIG. 2, the patterned layer 102 is covered with a conductive layer 104 that comprises copper or a copper alloy in the preferred embodiment. Conductive layer 104 is deposited using a deposition technique suited to fill openings 103. Suitable methods of depositing conductive layer 104 include sputtering, chemical vapor deposition, electroplating and the like. To ensure completely filling openings 103, conductive layer 104 is desirably applied at a thickness somewhat greater than the depth of openings 103.

As shown in the cross-section of FIG. 3, an upper portion of conductive layer 104 is removed by a planarizing process such as chemical mechanical planarization (CMP) or by mechanical polishing. These processes comprise wet chemical removal and/or physical removal steps and so are applicable to conductive layer such as copper than are difficult to etch using dry etch techniques. The resulting structure shown in FIG. 3 has a substantially planar upper surface with interconnect wiring 106 embedded in sacrificial layer 102.

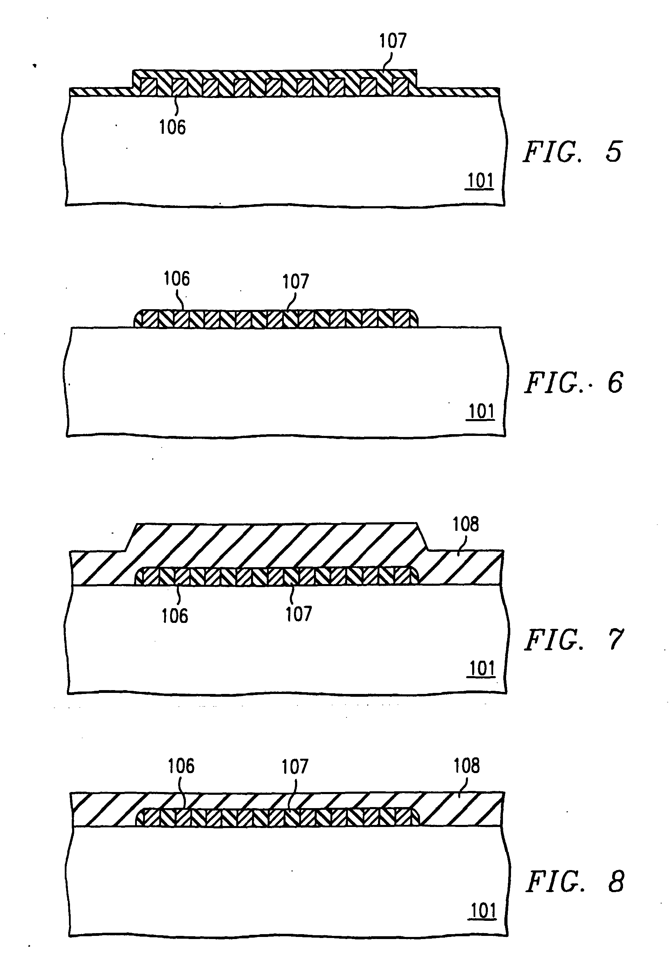

After planarization, sacrificial layer 102 is removed by wet or dry etching techniques that do not substantially etch or damage interconnect wires 106. The resulting structure shown in FIG. 4 comprises interconnect wires 106 having dimensions determined by the patterned formed in sacrificial layer 102. Optionally, the sidewalls of wires 106 may be protected by a thin layer of material (not shown) such as oxide, nitride or the like using a sidewall spacer formation process. This protective layer may be used to prevent chemical interaction between low-ε dielectric spacers 107 (shown in FIG. 6) if desired. Similar protection may be achieved by oxidizing interconnect wires 106.

A low-ε dielectric material applied in a conformal layer 107 covering interconnect wires 106 and filling any spaces between wires 106 as shown in FIG. 5. Low-ε dielectric layer 107 is applied in a thickness sufficient to fill gaps between interconnect wires 106. Suitable low-ε dielectric materials include:
A. Parylene-N
B. Parylene-D
C. Parylene-C
D. Parylene-F
E. AF4
F. Copolymers of Parylene-N &
   (1) tetravinyl-teramethyl-cyclotetra-siloxane
   (2) silanes & siloxanes with multi-vinylic ligands; e.g. divinyl silane, octavinyl-cyclotetra-siloxane
   (3) Silyls,; e.g. trimethyl silylcyclo pentadiene.
G. Copolymers of Parylene-N & Parylene-F
H. Copolymers of Parylene-N and bridged rings; e.g., bicylooctene
I. Polyimides
J. Generally vapor-deposited polymers, polynaphthalenes, and some polyimides
K. Amorphous carbon
L. Amorphous fluorinated carbon
M. Fluorinated diamond-like carbon

Preferably, low-ε dielectric layer 107 comprises a material that can be dry etched by, for example, reactive ion etching, without damaging conductive wires 106. Where copper is used for wires 106 dry etching is especially convenient because, as set out before, copper is difficult to etch in most dry etch chemistries. Low-ε dielectric layer 107 is etched until the surface of wires 106 is exposed leaving line-to-line dielectric spacers 107 as illustrated in FIG. 6. The etch of low-ε dielectric layer 107 can timed or an endpoint can be determined using time or by measuring etch by-products that will drop significantly when the upper surfaces of wires 106 are cleared. This results in a Damascene structure having low-ε material in the open areas where there are no metal lines.

As illustrated in FIG. 7, an insulating cap layer 108 is applied to cover interconnect wires 106 and low-ε dielectric spacers 107. Cap layer 108 comprises a conventional material used for interlayer dielectrics such as silicon oxides applied by chemical vapor deposition. Cap layer 108 provides an upper surface that protects low-ε dielectric spacers 107, is thermally stable, and mechanically rugged. Cap layer 108 is planarized by, for example, CMP processing to provide the structure shown in FIG. 8. Cap layer should also be of a material with higher dielectric constant than low-ε spacer material.

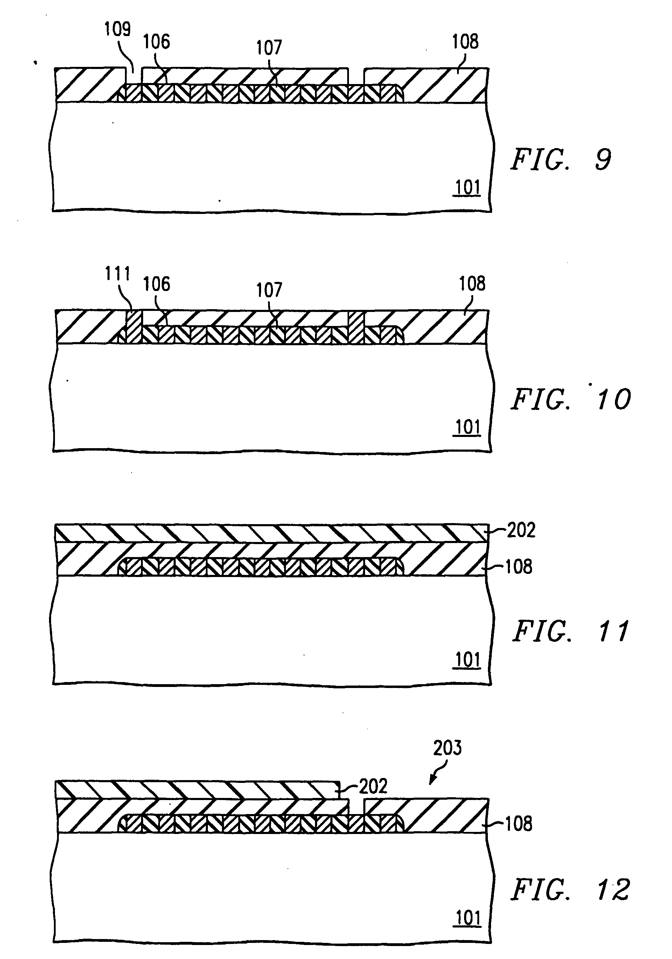

The upper surface of the structure shown in FIG. 8 is substantially planar and is compatible with existing Damascene and via fill techniques to form electrical connections to interconnect wires 106 as shown in FIG. 9 and FIG. 10. Vias 109 are etched using available patterning and etch techniques to expose the upper surface of selected portions of interconnect wires 106. Vias 109 are filled with a suitable conductive material to provide electrical connection to the selected wires 106 as shown in FIG. 10.

FIG. 11 through FIG. 15 show an alternative dual Damascene implementation to the previous teachings. This embodiment begins with a structure substantially as shown in FIG. 8. A second sacrificial layer 202 is formed covering an upper surface of cap dielectric 108 as shown in FIG 11. Second sacrificial layer 202 comprises the same material applied in a similar manner as sacrificial layer 102 described hereinbefore in a preferred implementation. As shown in FIG. 12, sacrificial layer 202 is patterned to open areas 203 where wiring will eventually be formed. A via may also be opened to expose selected portions of wires 106 to form inter-layer conductive connections.

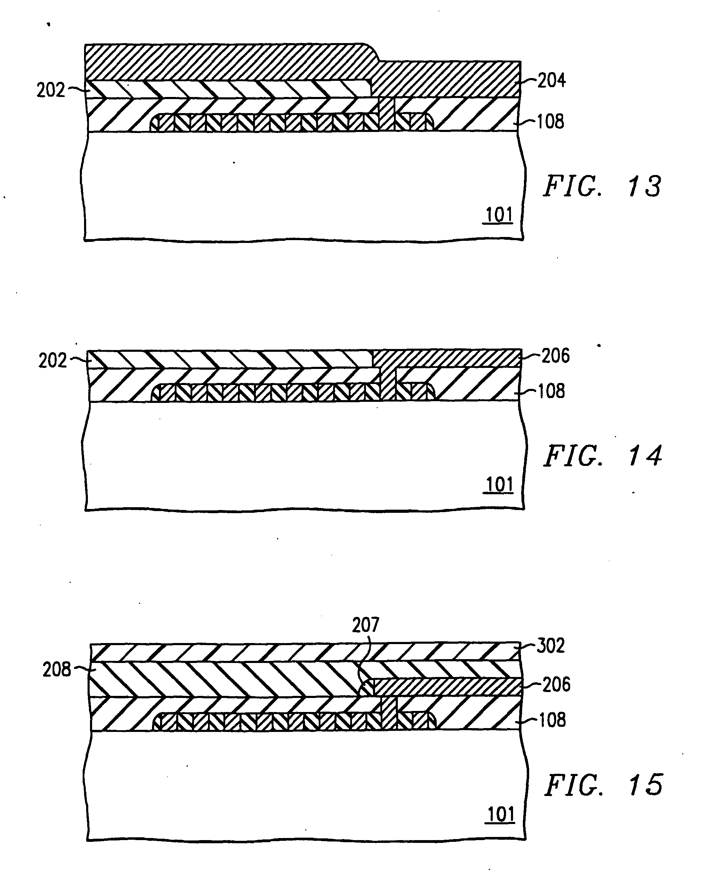

As shown in FIG. 13, conductive layer 204 is applied using, for example, blanket deposition techniques such as CVD or sputtering. Preferably, conductive layer 204 also comprises copper or a copper alloy to provide low resistance wiring. The composition of conductive layer 204 is chosen to be metallurgically compatible with conductive wires 106 to provide a high quality conductive coupling. The upper portion of conductive layer 204 is removed using a process comprising a mechanical removal step such as CMP. The removal process is desirably stopped when the upper surface of second sacrificial layer 202 is exposed as shown in FIG. 14. The removal process leaves a second layer of patterned conductive wiring 206 that is selectively coupled with the first layer of patterned wiring 106.

In accordance with these teachings, second sacrificial layer 202 is removed and embedded low-ε dielectric 207 shown in FIG. 15 is applied and formed in a manner similar to low-ε spacers 107 described herein before. After low-ε spacer 207 is patterned, a second cap layer 208 comprising, for example an oxide is applied and planarized to cover conductive wires 206 and low-ε spacers 207. Second cap layer 208 is conveniently planarized in a manner similar to first dielectric cap 108 described hereinbefore. As suggested by third sacrificial layer 302 shown in FIG. 15, the process may be extended through repetition of the steps outlined herein to any number of conductive layers required by a particular device design.

Although the invention has been described and illustrated with a certain degree of particularity, it is understood that the present disclosure has been made only by way of example, and that numerous changes in the combination and arrangement of parts can be resorted to by those skilled in the art without departing from the spirit and scope of the invention.

## Claims

1. A semiconductor device comprising:
a low-ε dielectric layer formed on a surface of an integrated circuit; and
interconnect wires inlaid in the dielectric and interconnecting at least portions of a plurality of devices forming said integrated circuit.

2. The body of Claim 1, wherein said low-ε dielectric layer is formed from a dielectric material comprising porous silicon dioxide.

3. The device of Claim 1 or Claim 2 further comprising:
an interlayer dielectric covering the inlaid interconnect wires and low-ε dielectric, the interlayer dielectric further comprising a low-ε dielectric.

4. The device of Claim 3 further comprising:
a via formed in the interlayer dielectric, and filled with a conductor.

5. The device of Claim 4, wherein said conductor comprises copper.

6. An integrated circuit comprising:
a plurality of devices formed in a semiconductor body;
a plurality of Damascene interconnect wires interconnecting at least portions of the plurality of devices; and
a dielectric material formed over the Damascene interconnect wires, wherein said dielectric material comprises a low-ε dielectric.

7. A method of forming an interconnect layer in a semiconductor device comprising:
forming a sacrificial layer over a surface of a semiconductor substrate;
patterning the sacrificial layer to form troughs in the sacrificial layer;
filling the troughs with a conductor to form interconnect lines; and
removing a remainder of the sacrificial layer.

8. The method of Claim 7, wherein said step of filling the troughs with a conductor comprises filling the troughs with a conductor comprising copper.

9. The method of Claim 7 or 8 wherein the step of removing comprises planarizing the surface of the sacrificial layer after the step of filling the troughs.

10. The method of any of Claims 7 to 9, wherein the step of forming a sacrificial layer comprises forming a photoresist layer on the surface of the semiconductor body.

11. The method of any of Claims 7 to 10, wherein the step of patterning comprises exposing contact areas on the underlying semiconductor substrate.

12. The method of any of Claims 7 to 11 further comprising:
forming a first low-ε dielectric layer over the conductor after the step of removing the sacrificial layer; and
removing the first dielectric layer to expose the top surface of open field areas of the semiconductor substrate.

13. The method of Claim 12 further comprising:
covering the embedded dielectric and exposed conductor with a second dielectric layer of higher dielectric permittivity;
forming vias in the second dielectric layer; and
filling the vias with a conductor.

14. The method of Claim 13, wherein the step of filling the vias with a conductor comprises filling the vias with a conductor comprising copper.
